# EUROPEAN PATENT APPLICATION

(11) **EP 3 193 093 A2**
(43) Date of publication of application: **19.07.2017**
(21) Application number: 17151738.6
(22) Date of filing: 17.01.2017
(51) Int. Cl.: F24F 5/00, H05K 7/20

(54) **CONDITIONING MACHINE OF THE FREECOOLING TYPE, PARTICULARLY FOR CONDITIONING COMPUTER CENTERS**

(30) Priority: 18.01.2016 IT UB20160149
(71) Applicant: Emerson Network Power S.R.L., 35028 Piove di Sacco (PD) (IT)
(72) Inventor: DE ZEN, Daniele, 35020 CORREZZOLA PD (IT)
(74) Representative: Modiano, Micaela Nadia

(57) **Abstract**

A conditioning machine of the freecooling type (10), particularly for conditioning computer centers, of the type comprising, arranged in a box-like container (11):
- a water evaporation device (12), for cooling a conditioning air flow (13), comprising in turn:
- an air/air heat exchanger (14),
- water dispensing means (15), adapted to wet from above the air/air heat exchanger (14),
- collecting means (16) for the water that descends from the air/air heat exchanger (14),
- a recirculation pump (17) for the rise of the air cooling water from the collecting means (16) to the dispensing means (15) arranged above the air/air heat exchanger (14),
- fans (18) for moving the air flow (13),
- external air filters (19) for an input air flow (33);
the external air filters (19) comprise glass fiber filtering material.

## Description

The present invention relates to a conditioning machine of the freecooling type, particularly for conditioning computer centers.

Conditioning systems of the indirect or direct freecooling type for conditioning computer centers are currently known and widespread.

The term "freecooling" designates the particular function of a conditioning system of using external air if conditions allow to do so.

These systems use water evaporation devices as a main air cooling system and said air is drawn from outside, cooled and introduced directly in the computer center, a system known in the jargon as "direct freecooling", or they use evaporation machines comprising an air/air exchanger for cooling with external air the warm air that returns from said computer center, which is then returned to said computer center, a system known in the jargon as "indirect freecooling".

These free cooling systems are therefore provided with conditioning machines which comprise, arranged in a box-like container:
- a water evaporation device, for cooling a conditioning air flow, comprising in turn:
- an air/air heat exchanger,
- water dispensing means, adapted to wet from above said air/air heat exchanger,
- collecting means for the water that descends from the heat exchanger,
- a recirculation pump for the rise of the air cooling water from the collecting means to the dispensing means arranged above the heat exchanger,
- fans for moving said air flow,
- external air filters for an input air flow.

In the case of an indirect freecooling machine, an external cooling air flow enters from the external air filters arranged in the lower part of the machine and then flows upward from below over the heat exchanger, which in turn is wet by the water of the evaporation device.

The external air filters are therefore located close to the means for collecting the water that descends from the heat exchanger.

These filters typically comprise open-cell polyester sheets as filtering materials.

These air filters are designed to prevent the intrusion, together with the aspirated cooling air, of dust and other substances that might obstruct the passage of said air through the air/air heat exchanger, reducing the efficiency of the conditioning unit.

At the same time, splashes rise from the water collecting means and gather on said polyester sheets, impregnating them and partially obstructing the passage of air from the outside toward the inside of the machine, with a consequent reduction of the efficiency thereof.

Furthermore, since these machines are generally placed so as to operate outdoors, in case of intense cold the water with which known filters become impregnated might freeze, with consequent damage to the filter itself and consequently to the correct operation of the machine.

Another limitation of known machines is that they have filters which, due to their inherent impregnability, are ill-suited to be scrubbed and reused.

The aim of the present invention is to provide a conditioning machine of the freecooling type, particularly for conditioning computer centers, that is capable of obviating the cited limitations of known machines.

Within this aim, an object of the invention is to provide a machine that is fully efficient even when the filters are affected by splashes of water that arrive from an evaporation device that is internal to said machine.

Another object of the invention is to provide a machine that can be restored easily to full efficiency in case of clogged filters.

A further object of the invention is to provide an external air filter to be applied in a machine according to the invention.

This aim, as well as these and other objects that will become better apparent hereinafter, are achieved by a conditioning machine of the freecooling type, particularly for conditioning computer centers, of the type comprising, arranged in a box-like container:
- a water evaporation device, for cooling a conditioning air flow, comprising in turn:
- an air/air heat exchanger,
- water dispensing means, adapted to wet from above said heat exchanger,
- collecting means for the water that descends from the heat exchanger,
- a recirculation pump for the rise of the air cooling water from the collecting means to the dispensing means arranged above the heat exchanger,
- fans for moving said air flow,
- external air filters for an input air flow,
said machine being characterized in that said external air filters comprise glass fiber filtering material.

Further characteristics and advantages of the invention will become better apparent from the description of a preferred but not exclusive embodiment of the machine according to the invention, illustrated by way of nonlimiting example in the accompanying drawings, wherein:
Figure 1 is a schematic side view of a machine according to the invention;
Figure 2 is a schematic sectional front view of a machine according to the invention;
Figure 3 is a perspective view of an input air filter for a machine according to the invention;
Figure 4 is a sectional view of a detail of a filter according to the invention.

With reference to the cited figures, a conditioning machine of the freecooling type is generally designated by the reference numeral 10.

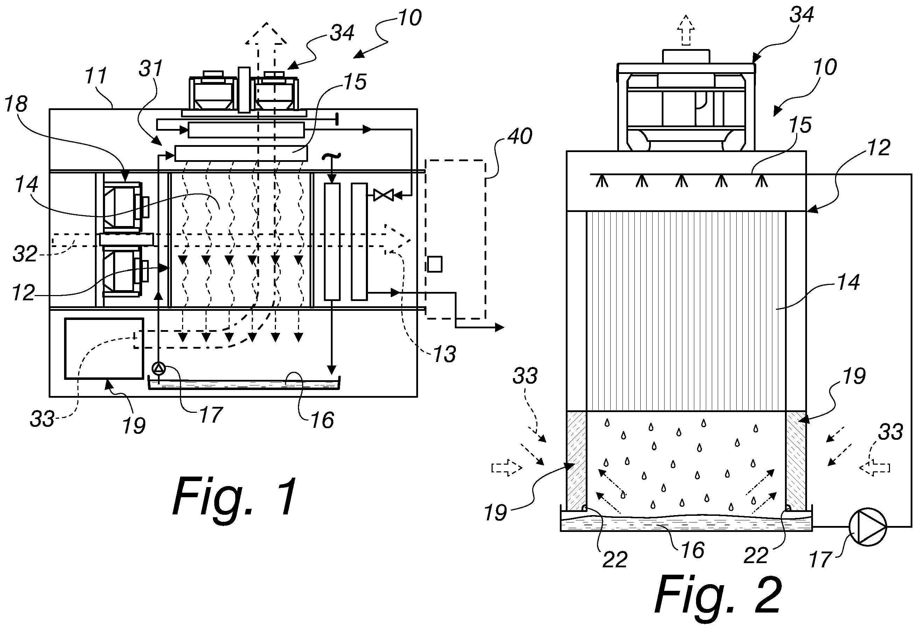

The machine 10, particularly for conditioning computer centers, is of the type that comprises, arranged in a box-like container 11:
- a water evaporation device 12, for cooling a conditioning air flow 13, comprising in turn:
- an air/air heat exchanger 14,
- water dispensing means 15, adapted to wet from above the air/air heat exchanger 14, for example a plurality of atomizing nozzles,
- collecting means 16 for the water that descends from the air/air heat exchanger 14, for example a collecting tank,
- a recirculation pump 17 for the rise of the air cooling water from the collecting means 16 to the dispensing means 15 arranged above the heat exchanger 14,
- fans 18 for moving the conditioning air flow 13, which is directed toward an environment to be climate-controlled, such as for example a server room 40,
- external air filters 19 for an input air flow, designated by 33 in Figure 2.

The particularity of the machine 10 according to the invention resides in that the external air filters 19 comprise filtering material made of glass fiber.

In particular, in the present constructive example, each one of the external air filters 19 comprises a containment frame 20, inside which there is a filtering sheet 21 which comprises glass fiber.

The containment frame 20 has at least one discharge hole, for example a series of discharge holes 22, 23, 24 and 25, for draining the accumulated liquid, which are open onto the lower side 26 of the containment frame 20 in the configuration for use.

The air filters 19 are therefore arranged vertically in the configuration for use, therefore with the discharge holes arranged downward.

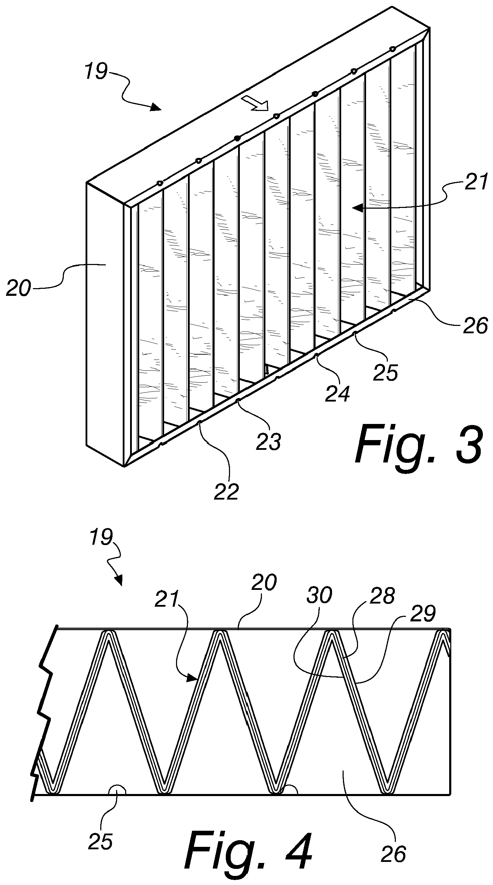

The filtering sheet 21 comprises, by way of nonlimiting example of the invention, a glass fiber layer 28 which is sandwiched between two metallic nets 29, 30, as shown in the schematic sectional view of Figure 4.

Each external air filter 19 is arranged so as to discharge the accumulated liquid in the collection means 16, as clearly visible in Figure 2.

The filters thus provided and positioned act as a water barrier both from the outside inward and from the inside outward.

In the present constructive example, the machine 10 according to the invention is of the indirect freecooling type and comprises:
- an air/air heat exchanger, of a known type and generally designated by the reference numeral 14, inside which two air flows 32 and 33 exchange heat: a primary air flow 32, which arrives from a server room 40 and is directed toward said server room to be climate-controlled 40, and a secondary air flow or process flow, which is drawn from outside.

Such a machine 10 therefore comprises:
- the air/air heat exchanger 14,
- water dispensing means 15, adapted to wet from above the air/air heat exchanger 14,
- the collecting means 16,
- the recirculation pump 17,
- first fans 18 for moving the primary air flow 32, which in output from the exchanger 31 becomes the conditioning flow 13,
- and second fans 34 for moving the secondary air flow 33.

It should be understood that the invention can also be provided by means of a machine of the direct freecooling type, the external air filters 19 being in any case arranged indeed in input to the external air intake.

The invention also relates to an external air filter 19.

The external air filter 19, for conditioning machines of the freecooling type, particularly for conditioning computer centers, is characterized in that it comprises a containment frame 20 inside which there is a filtering sheet 21 which comprises glass fiber, the containment frame 20 having at least one discharge hole 22 for the accumulated liquid that is open on the lower side 26 of the containment frame 20 in the configuration for use, as described above.

In practice it has been found that the invention achieves the intended aim and objects.

In particular, the invention provides a machine with air filters on the outer side in order to avoid the intrusion of dust and other substances that might obstruct the passage of air, reducing the efficiency of the unit, said external air filters comprising glass fibers, in order to separate the liquid part from the air flow.

These external air filters with glass fibers cause the water affected by said glass fibers to flow along the fibers, therefore not remaining stationary on the surface of the filter, and being then collected in a lower region in the frame of said filter, which acts as a drainage tank.

The invention provides a machine the external air filters of which do not remain impregnated, and therefore if a filter gets wet, due to rain or fog, and the temperature of the air is low enough, there is no risk of freezing of the filter.

Moreover, the invention provides a machine the filters of which, made of glass fiber with a frame that collects and drains the water, act as a barrier for water both from the outside inward, for example in case of rain, both from the inside outward, since inside the machine there is the flow of water that is atomized on the air/air heat exchanger, which is recirculated and falls by gravity onto the bottom and bounces, propelling splashes of water in its vicinity, where the glass fiber filters are placed, affecting said splashes.

Furthermore, said glass fiber filters are fire resistant.

Moreover, the invention provides a machine the glass fiber filters of which, being composed of filaments, can be washed and do not retain the water used for washing, which would be dirty.

Finally, the invention provides an external air filter that is designed for application in said machine according to the invention.

The invention thus conceived is susceptible of numerous modifications and variations, all of which are within the scope of the appended claims; all the details may further be replaced with other technically equivalent elements.

In practice, the components and the materials used, so long as they are compatible with the specific use, as well as the contingent shapes and dimensions, may be any according to the requirements and the state of the art.

The disclosures in Italian Patent Application no. 102016000003740 (UB2016A000149), from which this application claims priority, are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A conditioning machine of the freecooling type (10), particularly for conditioning computer centers, of the type comprising, arranged in a box-like container (11):
- a water evaporation device (12), for cooling a conditioning air flow (13), comprising in turn:
- an air/air heat exchanger (14),
- water dispensing means (15), adapted to wet from above said air/air heat exchanger (14),
- collecting means (16) for the water that descends from the air/air heat exchanger (14),
- a recirculation pump (17) for the rise of the air cooling water from the collecting means (16) to the dispensing means (15) arranged above the air/air heat exchanger (14),
- fans (18) for moving said air flow (13),
- external air filters (19) for an input air flow (33),
said machine being **characterized in that** said external air filters (19) comprise glass fiber filtering material.

2. The machine according to claim 1, **characterized in that** each one of said external air filters (19) comprises a containment frame (20) inside which a filtering sheet (21) comprising glass fibers is arranged, said containment frame (20) having at least one discharge hole (22) for the accumulated liquid that is open on the lower side (26) of the containment frame (20) in the configuration for use.

3. The machine according to one or more of the preceding claims, **characterized in that** said filtering sheet (21) comprises a glass fiber layer (28) sandwiched between two metallic nets (29, 30).

4. The machine according to one or more of the preceding claims, **characterized in that** each external air filter (19) is arranged so as to discharge the liquid accumulated in said collecting means (16).

5. An external air filter (19) for conditioning machines of the freecooling type, particularly for conditioning computer centers, **characterized in that** it comprises a containment frame (20) inside which a filtering sheet (21) comprising glass fibers is arranged, said containment frame (20) having at least one discharge hole (22) for the accumulated liquid that is open on the lower side (26) of the containment frame (20) in the configuration for use.
